# EUROPÄISCHE PATENTSCHRIFT

(11) **EP 0 321 909 B1**
(45) Veröffentlichungstag und Bekanntmachung des Hinweises auf die Patenterteilung: **01.12.1993**
(21) Anmeldenummer: 88121243.5
(22) Anmeldetag: 19.12.1988
(51) Int. Cl.: H01L 21/20, C30B 25/02, C30B 29/40

(54) **Verfahren und Vorrichtung zum Atomschicht-Epitaxie-Aufwachsen**
Process and apparatus for atomic-layer epitaxy
Procédé et appareillage pour l'épitaxie par couches monoatomiques

(30) Priorität: 23.12.1987 DE 3743938
(43) Veröffentlichungstag der Anmeldung: 28.06.1989
(73) Patentinhaber: CS HALBLEITER-UND SOLARTECHNOLOGIE GMBH, D-80339 München (DE)
(72) Erfinder: Scholz, Christoph, Dr., D-8162 Schliersee (DE)
(74) Vertreter: Haft, von Puttkamer, Berngruber, Czybulka

(56) Entgegenhaltungen:
- EP-A- 0 015 390
- EP-A- 0 068 839
- JP-A- 6 287 485
- EXTENDED ABSTRACTS OF THE 19TH CONFERENCE ON SOLID STATE DEVICES AND MATERIALS, Tokyo, 25. - 27. August 1987, Seiten 475-478; M. OZEKI et al.: "Growth of AlGaAs by atomic layer epitaxy using a pulsed vapor phase method"

## Beschreibung

Die Erfindung bezieht sich auf ein Verfahren zum Atomschicht-Epitaxie-Aufwachsen einer Halbleiter-Dünnschicht auf einer Substratoberfläche nach dem Oberbegriff des Anspruchs 1. Die Erfindung hat ferner eine Vorrichtung zum Gegenstand, die sich zur Durchführung dieses Verfahrens eignet.

Um einen epitaktischen, d. h. kristallografisch orientierten, monokristallinen Halbleiter, z. B. aus den Elementen A und B herzustellen, wird das Atomschicht-Epitaxie-Verfahren angewendet. Dabei wird dem erhitzten Substrat zunächst eine Verbindung des Elements A zugeführt, bis die Substratoberfläche mit einer monomolekularen Schicht oder A-Monolage bedeckt ist, worauf die Verbindung des Elements B zugeführt wird, um mit der A-Monolage unter Bildung einer AB-Monolage zu reagieren. Dieser Zyklus wird wiederholt, bis die gewünschte Schichtdicke erreicht ist. Das Element A kann dabei ein Element der Gruppe II des Periodensystems und das Element B ein Element der Gruppe VI des Periodensystems sein (II/VI-Verbindungshalbleiter) bzw. ein Element der Gruppe III, wie Aluminium, Gallium oder Indium, und ein Element der Gruppe V, z. B Stickstoff, Phosphor, Arsen oder Antimon (III/V-Verbindungshalbleiter). Falls ein IV/IV-Verbindungshalbleiter hergestellt werden soll, kann das Element Silicium, Germanium oder Kohlenstoff sein (z. B. Si-Si-, Si-Ge-, Si-C- oder Ge-Ge-Halbleiter). Die Zufuhr der Verbindungen von A und B erfolgt mit einem Trägergas.

Beim Atomschicht-Epitaxie-Aufwachsen von Galliumarsenid aus einer metallorganischen Galliumverbindung, z. B. Triethylgallium (TEG), und Arsin (AsH₃) ist festgestellt worden, daß die gebildete Schicht eine hohe p-Leitfähigkeit und niedrige Elektronenmobilität aufweist. Dies ist darauf zurückzuführen, daß während der Adsorption der Galliumverbindung Arsen von der Oberfläche verdampft und zu Fehlstellen führt. Um der Verdampfung von Arsen von der Halbleiteroberfläche entgegenzuwirken, ist vorgeschlagen worden, während der Zufuhr des TEG dessen Trägergas mit einer geringen Menge Arsin zu versetzen (Japanese Journal of Applied Physics, Vol. 24, Nr. 12, Dezember 1985, Seiten L 962 bis L 964; Inst. Phys. Conf., Ser. Nr. 83, Ch. 1, Intern. Symp. GaAs and Related Compounds, 1986, Seiten 1 bis 8; Jap. J. of Appl. Phys., Band 25, Nr. 6, 1986, Seiten L 513 bis L 515). Als Trägergas wird dabei Wasserstoff verwendet.

Dadurch wird zwar die p-Leitfähigkeit etwas verringert und die Elektronenmobilität geringfügig erhöht, jedoch wird ein Vorgang noch problematischer, der schon beim normalen Atomschicht-Epitaxie-Aufwachsen, also wenn z. B. abwechselnd reines Arsin und TEG der Kammer zugeführt werden, unvermeidlich ist. Durch die Reste der einen gasförmigen Verbindung, also z. B. des Arsins in der Kammer bei der Zufuhr der anderen gasförmigen Verbindung, also z. B. TEG, kommt es nämlich zu einer Reaktion der beiden Verbindungen in der Gasphase und damit durch Addukt- und Keimbildung zu Niederschlägen an der Kammerinnenwand und dgl., wodurch sich die Eigenschaften der Halbleiter-Dünnschicht drastisch verschlechtern. Durch die Zugabe von Arsin bei Zufuhr des TEG, wie es in diesen Literaturstellen vorgeschlagen wird, werden diese Gasphasenreaktionen freilich noch wesentlich gefördert.

Zugleich ist Arsin als sehr giftiges Gas strengen gesetzlichen Auflagen unterworfen. Bei dem bekannten Verfahren wird durch die ständige Arsin-Zufuhr jedoch wesentlich mehr Arsin eingesetzt als zur Halbleiterbildung verbraucht wird, so daß sich erhebliche Arsin-Entsorgungsprobleme ergeben.

Um die Bildung von Kristallkeimen beim Atomschicht-Epitaxie-Verfahren zurückzudrängen, wird nach der EP-A-0015390 zwischen der abwechselnden Zufuhr der Verbindungen der Elemente des Halbleiters ein inertes Spülgas, z. B. Argon, zugeführt, um jeglichen Kontakt der Verbindungen miteinander und damit die Addukt- und Keimbildung zu verhindern. Die nach diesem Verfahren hergestellte Halbleiterschicht zeichnet sich allerdings durch eine unerwünscht hohe p-Leitfähigkeit und niedrige Elektronenmobilität aus. Gleiches gilt für das Verfahren nach EP-A-0068839, bei dem ein gemisch aus Wasserstoff und einem Inertgas als Trägergas verwendet wird.

Nach dem Stand der Technik werden zwei Typen von Vorrichtungen zur Herstellung von Halbleiterdünnschichten durch Atomschicht-Epitaxie-Aufwachsen verwendet, nämlich der vertikale Reaktor und der horizontale Reaktor.

Während beim vertikalen Reaktor das Substrat, auf dem die Halbleiterdünnschicht aufwächst, in einer Radialebene der zylindrischen Reaktorkammer, d. h. senkrecht zur Zylinderachse des Reaktors bzw. zur Gasströmungsrichtung angeordnet ist, erstreckt sich das Substrat beim horizontalen Reaktor in Reaktorlängsrichtung, also in Gasströmungsrichtung.

Beide Reaktortypen genügen jedoch nicht den höchsten Anforderungen, insbesondere lassen sie nicht die erforderliche Gleichmäßigkeit der Beschichtung hinsichtlich Schichtdicke und Zusammensetzung zu.

So trifft beim horizontalen Reaktor das Gas zunächst auf den dem Gaseinlaß zugewandten Bereich des Substrats auf, so daß dort die Schichtdicke der Halbleiterdünnschicht am größten ist und in Strömungsrichtung des Gases abnimmt, wobei sich die Zusammensetzung entsprechend ändern kann. Ursache dafür sind auch Gasturbulenzen in dem dem Einlaß zugewandten Bereich des Substrats.

Beim vertikalen Reaktor wird das Gas der zylindrischen Kammer über einen Trichter geführt, an dessen in der Zylinderachse der Kammer liegenden Spitze der Gaseinlaß angeordnet ist. Die Hauptströmungsrichtung des Gases verläuft damit in der Zylinderachse der Kammer und nach dem Auftreffen des Gases auf das Substrat in radialer Richtung. Damit wird in der Mitte des Substrats die Beschichtung dicker als zum Rand hin und hinsichtlich der Zusammensetzung kann ebenfalls eine Änderung von der Substratmitte zum Rand auftreten. Diese Ungleichmäßigkeiten lassen sich zwar durch einen langen Trichter mit einem spitzen Trichterwinkel etwas mindern, dadurch wird jedoch das Gasvolumen in der Kammer vergrößert, also insbesondere der Gaswechsel erschwert. Auch werden die erwähnten Probleme der Entsorgung der zumeist giftigen, gasförmigen Verbindungen der Elemente des Halbleiters, z. B. des Arsins, erschwert, und die Addukt- und Keimbildung wird gefördert.

Aufgabe der Erfindung ist es, bei einem Verfahren der eingangs genannten Art, die zu entsorgende Menge giftiger Gase, wie Arsin, spürbar herabzusetzen, und zwar bei Steigerung der Qualität der Halbleiterschicht, d. h. insbesondere unter Herabsetzung der Verdampfung von Elementen, wie Arsen, von der Halbleiteroberfläche sowie ohne Addukt- und Keimbildung durch Gasphasenreaktion der Verbindungen.

Dies wird erfindungsgemäß durch das im Anspruch 1 gekennzeichnete Verfahren erreicht. Vorteilhafte Ausgestaltungen des erfindungsgemäßen Verfahrens sind in den Ansprüchen 2 bis 5 angegeben.

In den Ansprüchen 6 bis 10 ist eine Vorrichtung bzw. ein Reaktor angegeben, der sich zur Durchführung des erfindungsgemäßen Verfahrens besonders eignet.

Erfindungsgemäß wird also als Trägergas ein Gemisch aus Wasserstoff und Edelgas eingesetzt.

Ferner wird beim erfindungsgemäßen Verfahren zur Verhinderung der Addukt- und Keimbildung die Kammer vorzugsweise zwischen der abwechselnden Zuführung der Verbindungen jeweils evakuiert oder mit einem Spülgas gespült. Als Spülgas wird dabei zweckmäßigerweise ebenfalls ein Edelgas verwendet.

Wie sich herausgestellt hat, führt die Verwendung von Wasserstoff als Träger- oder Spülgas nach dem Stand der Technik nämlich dazu, daß aus der Halbleiteroberfläche Elemente herausgelöst, also gewissermaßen herausgeätzt werden. Wie festgestellt werden konnte, verläuft die Bildung der Hydride zumindest von einem Teil dieser Elemente nämlich stark exotherm. So haben Berechnungen ergeben, daß die Enthalpie der Bildung von Arsin durch Reaktion von GaAs mit H₂ bei 800 K ca. minus 85 kJ/mol beträgt.

Bei dem erfindungsgemäßen Verfahren braucht jedoch nicht der gesamte Wasserstoff durch ein Edelgas ersetzt zu werden. Vielmehr werden die erfindungsgemäßen Vorteile bereits spürbar, wenn nur ein Teil des Träger- bzw. Spülgases aus einem Edelgas besteht. Im allgemeinen beträgt der Anteil des Edelgases im Trägergas bzw. Spülgas jedoch mehr als 50 Vol.-%, besonders bevorzugt mehr als 80 Vol.-%. D. h., der Wasserstoffgehalt im Trägergas und Spülgas ist im allgemeinen kleiner als 50 Vol.-%, vorzugsweise kleiner als 20 Vol.-%.

Ein gewisser Wasserstoffgehalt von z. B. mindestens 5 Vol.-% im Träger- bzw. Spülgas wird jedoch bevorzugt, weil dadurch eine reduzierende Atmosphäre sichergestellt wird, die Verunreinigungen, die durch Oxidationen verursacht werden, verhindert.

Vorteilhafterweise setzt man Arsin und/oder Phosphin während sämtlicher Zyklen des Epitaxie-Aufwachsens in einem gewissen Anteil zu, also auch während des Spülens mit dem Spülgas und während der Zufuhr der Diethyl-Verbindung. Die Menge des Arsin und/oder Phosphin in dem Spülgas bzw. bei Zufuhr der Diethyl-Verbindung wird vorzugsweise so bemessen, daß dadurch ein Dampfdruck des Arsens und/oder Phosphors erzeugt wird, der dem Dampfdruck dieses Elements über der erhitzten Halbleiterschicht möglichst entspricht.

Statt ein Spülgas zuzuführen, kann erfindungsgemäß die Kammer zwischen der Zuführung der gasförmigen Verbindungen auch evakuiert werden. Ferner kann auch beim Evakuierschritt eine geringe Menge Arsin und/oder Phosphin (ohne Spülgas) zugeführt werden.

Bei der Herstellung eines Galliumarsenid-(GaAs)-Halbleiters nach dem erfindungsgemäßen Verfahren ist keinerlei Keimbildung zu beobachten. Dies ist ein im Hinblick auf den vorstehend geschilderten Stand der Technik völlig überraschendes Ergebnis. Vor allem aber ist die p-Leitfähigkeit drastisch zurückgedrängt und eine überraschend hohe Elektronenleitfähigkeit erreicht.

Falls erfindungsgemäß ein GaAs-Halbleiter aus Arsin und Galliumdiethylchlorid hergestellt werden soll, beträgt der Dampfdruck der As₂-Moleküle bei einer Substrat-Temperatur von ca. 600°C über der GaAs-Schicht etwa 10⁻⁵ Pa. Demgemäß wird das Arsin bei Spülgaszufuhr und bei Zufuhr des Galliumdiethylchlorids in einer solchen Menge zugesetzt, daß sich in dem zugeführten Gasgemisch ein As₂-Druck von mindestens etwa 10⁻⁵ Pa bei 600°C einstellen würde.

Nach dem erfindungsgemäßen Verfahren können vorteilhaft Gallium-Aluminium-Arsenid-Halbleiter der Formel Ga₁₋ₓAlₓAs, wobei x = 0 bis 1 sein kann, also eine Galliumarsenid- bzw. eine Aluminiumarsenid-Halbleiterschicht vorliegen kann, gebildet werden. Dabei läßt man vorzugsweise alternierende Schichten aus mehreren Monolagen von GaAs und mehreren Monolagen von GaAlAs aufwachsen, d. h. es wird eine Heterostruktur gebildet, so daß an der Phasengrenze der Schichten sich ein zweidimensionales Elektronengas ausbildet.

Ebenso kann erfindungsgemäß in vorteilhafter Weise ein Indium-Gallium-Arsenid-Phosphid-Halbleiter der Formel In₁₋ₓGaₓAs_{1-y}P_{y}, also ein quaternäres System, hergestellt werden, wobei x = 0 bis 1 und y = 0 bis 1 sein kann, so daß z. B. bei x = 0 und y = 1 eine Indiumsphosphid-Schicht gebildet wird oder bei x = 0,5 und y = 0 eine InGaAs-Schicht. Durch Ausbildung einer Heterostruktur durch schichtenweises Aufwachsen alternierender Schichten mit unterschiedlichem x und/oder y können wiederum zweidimensionale Elektronengas-Strukturen an den Phasengrenzen der Schichten erhalten werden, wobei bei einem solchen quaternären System eine optimale Anpassung der Gitterkonstanten bei der Heteroepitaxie verschiedener Verbindungen aneinander möglich ist.

Bei Herstellung eines GaAlAs- oder InGaAsP-Halbleiters mit einer Substrattemperatur zwischen 300 und 1000°C beträgt die Menge bzw. der Massenfluß des Arsins bzw. Phosphins in dem Spülgas und bei Zufuhr des Gallium-, Aluminium- oder Indiumdiethylchlorids im allgemeinen höchstens 8% und vorzugsweise weniger als 4% des maximalen Arsin- oder Phosphin-Massenflusses, d. h. des Arsin- oder Phosphin-Massenflusses bei denjenigen Schritten, bei denen jeweils eine As- bzw. P-Monolage gebildet wird.

Der Massenfluß des Arsins bzw. Phosphins bei Zufuhr des Spülgases und bei Zufuhr der Diethyl-Verbindungen erfolgen vorzugsweise rechnergesteuert in Abhängigkeit vom Arsen- oder Phosphor-Dampfdruck über dem Halbleiter bei der jeweiligen Substrattemperatur.

D. h., erfindungsgemäß kann es zwar von Vorteil sein, eine gewisse Menge Arsin bzw. Phosphin bei der Zufuhr der Diethyl-Verbindung sowie gegebenenfalls beim Spülschritt dem Trägergas bzw. Spülgas zuzusetzen. Die zugesetzte Arsin- bzw. Phosphinmenge ist jedoch in jedem Falle deutlich geringer als nach dem bekannten Verfahren. Zugleich ist zu berücksichtigen, daß nach dem erfindungsgemäßen Verfahren durch den geringen Wasserstoffanteil im Träger- bzw. Spülgas ein Herauslösen von Arsen und Phosphor aus der Halbleiteroberfläche unter Arsin- bzw. Phosphinbildung weitgehend verhindert ist. D. h., mit dem erfindungsgemäßen Verfahren werden die Probleme der Arsin- bzw. Phosphinentsorgung deutlich vermindert.

Erfindungsgemäß werden die Diethylchlorid-Verbindungen als metallorganische Verbindungen des Ga, Al und In eingesetzt.

Das Diethylchlorid hat z. B. gegenüber dem Dimethylchlorid den Vorteil, daß es sich bei relativ niedriger Temperatur unter Abspaltung von Ethen zersetzt, d. h. zur Umsetzung kein Wasserstoff erforderlich ist. Das Trägergas kann damit fast vollkommen aus Edelgas bestehen, d. h. ein Herausätzen von Arsen oder Phosphor aus der Oberfläche des Halbleiters durch H₂ ist weitestgehend verhindert.

Galliumdiethylchlorid (DEGaCl) ist also die metallorganische Galliumverbindung bei dem erfindungsgemäßen Verfahren. DEGaCl führt auch bei Abwesenheit von H₂, also in reinem Helium, bereits bei einer relativ niedrigen Temperatur von 350°C und einem relativ weiten Temperaturbereich bis 600°C und mehr zur Bildung exakt einer Monolage. Dadurch ist nicht nur die Temperaturkontrolle und -verteilung unkritisch. Vielmehr ist durch die relativ niedrige Temperatur des Substrats, die zur Bildung von Monolagen ausreicht, der Arsen- bzw.

Phosphor-Druck über der GaAs/P-Schicht besonders niedrig, so daß kein Arsen bzw. Phosphor von der Halbleiteroberfläche verdampft. Demgemäß kann auf einen AsH₃- bzw. PH₃-Gehalt bei Zufuhr des Spülgases und bei Zufuhr des DEGaCl gegebenenfalls völlig verzichtet werden, oder er kann verhältnismäßig gering eingestellt werden, womit die Gefahr einer Keimbildung, Adduktbildung usw. ausgeschlossen wird. Abgesehen davon, wirkt sich die niedrige Substrattemperatur günstig auf die Vermeidung von Interdiffusionen an Heterogrenzflächen aus.

Nach dem erfindungsgemäßen Verfahren können in die Halbleiterschicht Dotierstoffe eingebaut werden. Der Einbau der Dotierstoffe kann dabei gezielt dort ins Wirtsgitter erfolgen, wo sie je nach Leitungstyp (p oder n) bestimmte Gitteratome diadoch ersetzen sollen. So kann man z. B. p-Typ-Dotierstoffe, wie Be, Mg oder Zn, dem Trägergas des Elements der dritten Hauptgruppe, also z. B. der metallorganischen Galliumverbindung zusetzen, und solche vom n-Typ, wie S, Se oder auch Amphotere wie Si oder Sn, dem Trägergas des Arsins bzw. Phosphins.

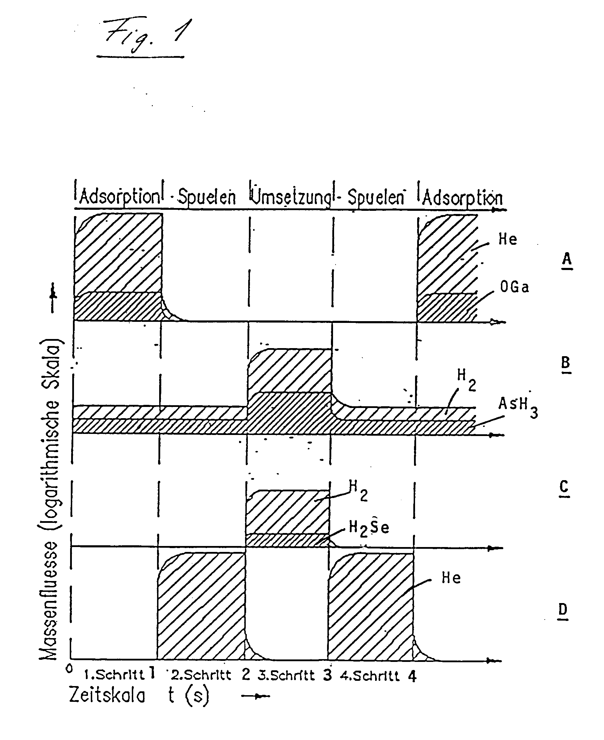

Nachstehend ist ein Ausführungsbeispiel der Erfindung anhand der Zeichnung näher erläutert, deren Fig. 1 ein Diagramm der Massenflußmodulation zum Aufwachsen von Se-dotiertem GaAs zeigt.

Darin stellen die Kurve A das Massenflußdiagramm eines Gemischs aus einer metallorganischen Galliumverbindung (OGa), nämlich DEGaCl, mit Helium (He) als Trägergas dar, die Kurve B das Massenflußdiagramm eines Gemischs aus Arsin (AsH₃) und Wasserstoff (H₂) als Trägergas, die Kurve C das Massenflußdiagramm eines Gemischs aus einem Dotierstoff (Do), z. B. H₂Se, und Wasserstoff (H₂) als Trägergas, und die Kurve D das Massenflußdiagramm des Spülgases (He).

Wie der Zeichnung zu entnehmen, setzt sich ein Monolagenzyklus, der insgesamt z. B. 4 sec beträgt, aus folgenden vier Schritten zusammen:
1. Adsorption der metallorganischen Galliumverbindung (OGa) - 1 sec;
2. Fluten mit He - 1 sec;
3. Umsetzung mit AsH₃ (und H₂Se) - 1 sec;
4. Fluten mit He - 1 sec

Wie der Kurve B zu entnehmen, wird dabei nicht nur beim Schritt 3, sondern auch während der Schritte 1, 2 und 4 eine geringe Menge AsH₃ und H₂ zugeführt.

Als Spülgas wird Helium verwendet, das zugleich als Trägergas für die metallorganische Galliumverbindung dient.

Die metallorganische Galliumverbindung wird über ihren Dampfdruck zudosiert. Dazu wird Helium durch einen thermostatisierten Blasenzähler geleitet, der die flüssige metallorganische Galliumverbindung enthält. p-Typ-Dotierstoffe können in gleicher Weise zudosiert werden. Als AsH₃/H₂-Gemisch für den Massenfluß der Kurve B kann ein handelsübliches Gemisch von z. B. 10 Vol.-% AsH₃ in H₂ verwendet werden. Dieses Gemisch wird ständig zugeführt, und zwar beim dritten Schritt der AsH₃-Umsetzung mit maximalem Massenfluß und sonst auf einen Wert von z. B. 3% des maximalen Massenflusses gedrosselt. Das Helium zum Spülen oder Fluten während des zweiten und des vierten Schritts jedes Zyklus stammt beispielsweise aus einer entsprechenden Gasbombe.

Der Druck in der Kammer beträgt während des Atomschicht--Epitaxie-Aufwachsens erfindungsgemäß vorzugsweise 10 bis 10000 Pa (0,1 bis 100 mbar) bei allen Schritten, falls ein Spülgas verwendet wird. Wird statt der Zuführung eines Spülgases zwischen der abwechselnden Zuführung der Verbindungen der Elemente evakuiert, so wird beim Evakuierschritt der Druck um den Faktor 100 bis 10000 gesenkt. D. h., z. B. bei einem Kammerdruck von 100 Pa während der abwechselnden Zuführung der Verbindungen wird der Druck auf z. B. 0,1 Pa beim Evakuierschritt dazwischen herabgesetzt.

Nach der Erfindung wird auch eine Vorrichtung bzw. ein Reaktor zur Herstellung von Halbleiterdünnschichten durch Atomschicht-Epitaxie-Aufwachsen zur Verfügung gestellt, mit der bzw. dem Halbleiterdünnschichten hoher Gleichmäßigkeit erhalten werden können. Der erfindungsgemäße Reaktor ist zur Durchführung des erfindungsgemäßen Verfahrens besonders geeignet.

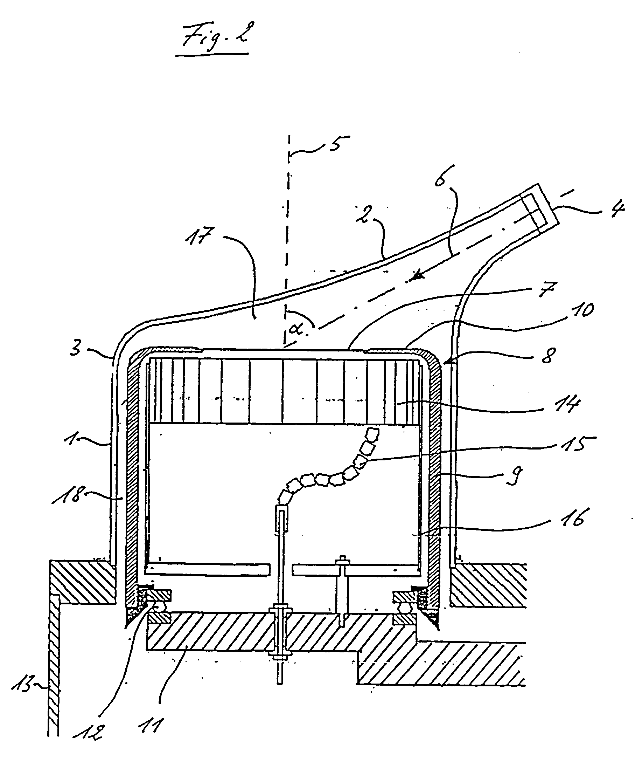

Nachstehend ist eine Ausführungsform des erfindungsgemäßen Reaktors anhand der Zeichnung näher erläutert, deren Fig. 2 schematisch einen Längsschnitt durch den Reaktor zeigt. Danach ist als Reaktionskammer ein Zylinder 1 am oberen Ende mit einer trichterförmigen Haube 2 versehen, welche sich von ihrer Basis 3, also ihrem unteren, mit dem Zylinder 1 verbundenen Ende zu ihrem oberen Ende hin verjüngt, an welchem sich der Gaseinlaß 4 befindet.

Der Gaseinlaß 4 ist dabei gegenüber der Zylinderachse 5 der Kammer radial versetzt angeordnet. D. h., die Trichterachse 6 der Haube 2 schließt mit der Zylinderachse 5 der Kammer einen Winkelα ein, der größer als 0 und kleiner als 90° ist, und zwar im allgemeinen 20 bis 70°, vorzugsweise 40 bis 60° beträgt.

Am oberen Ende des Zylinders 1, also im Bereich der Basis 3 der trichterförmigen Haube 2 ist in einer Radialebene zur Zylinderachse 5 das Substrat 7 angeordnet, auf dem die Halbleiterdünnschicht durch Atomschicht-Epitaxie-Aufwachsen gebildet werden soll.

Das Substrat wird durch einen Substrathalter 8 gehalten. Der Substrathalter 8 besteht aus einem zur Zylinderachse 5 koaxialen zylindrischen Abschnitt 9 und einem sich über eine abgerundete Kante nach innen zur Zylinderachse 5 erstreckenden Ringflansch 10, auf dem das Substrat 7 ruht.

Der Substrathalter 8 ist auf einer Grundplatte 11 um die Zylinderachse 5 drehbar gelagert. Dazu ist zwischen dem unteren Ende des zylindrischen Abschnitts 9 des Substrathalters 8 und der Grundplatte 11 ein Wälz- oder Kugellager 12 vorgesehen.

Die Reaktionskammer 1 sitzt mit ihrem unteren Ende auf einem Behälter 13, in dem auch die Grundplatte 11 befestigt ist, wobei der Behälter 13 an eine nicht dargestellte Vakuumpumpe angeschlossen ist.

Im Substrathalter 8 ist unterhalb des Ringflansches 10 ein elektrisches Heizelement 14 angeordnet, das an die Stromzuführung 15 angeschlossen ist. Zwischen dem Heizelement 14 einerseits und dem zylindrischen Abschnitt 9 des Substrathalters 8 sowie der Grundplatte 11 andererseits ist eine thermische Abschirmung 16 vorgesehen, die zugleich zur Befestigung des Heizelements 14 an der Grundplatte 11 dient.

Bei der erfindungsgemäßen Vorrichtung trifft das vom Einlaß 4 in die Reaktionskammer einströmende Gas schräg auf das Substrat 7 auf. Dies hat zur Folge, daß weder in der Mitte, wie bei dem Vertikalreaktor, noch am Rand, wie bei dem Horizontalreaktor, ein stärkeres Wachstum auftritt, als in den übrigen Substratbereichen. D. h., mit der erfindungsgemäßen Vorrichtung erfolgt ein gleichmäßiges Wachstum der Halbleiterdünnschicht in allen Bereichen.

Durch die schräge Anordung der Trichterachse 6 gegenüber der Zylinderachse 5 und damit der Hauptströmungsrichtung der Gase ist nämlich das Substrat 7 schräg zur Hauptströmungsrichtung der Gase angeordnet. Dadurch kommt es zu einer Verdichtung der Gase im Bereich 17 der Haube 2 über dem Substrat 7, welcher dem Gaseinlaß 4 gegenüber liegt und damit zu einer gleichmäßigen Abreicherung der Gase.

Zugleich ist durch die schräge Ausbildung der Haube 2 deren Innenvolumen und damit das Gasvolumen in dem Reaktor gering. Dies hat zur Folge, daß die Menge der zum Teil sehr giftigen Verbindungen der Halbleiterelemente, die der aus Haube 2 und Zylinder 1 bestehenden Reaktionskammer abwechselnd zugeführt werden, relativ gering ist und daß der Gaswechsel, d. h. das Absaugen der Gase aus der Haube 2 über den Ringspalt 18 zwischen dem zylindrischen Abschnitt 9 des Halters 8 und der Innenwand des Zylinders 1 der Reaktionskammer schnell durchgeführt werden kann.

Auch kann der Ringspalt 18 relativ eng ausgebildet werden. Dies hat zur Folge, daß der Substrathalter 8 als Turbinenlaufrad rotierbar ausgebildet werden kann, wobei die in der Zeichnung nicht dargestellten Schaufeln oder sonstige Gasleitelemente des Turbinenlaufrades bzw. des Substrathalters 8 in dem Ringspalt 18 angeordnet sind.

Durch die Rotation des Substrathalters 8 und damit des Substrats 7 wird eine gleichmäßige Verteilung der von dem Heizelement 14 an das Substrat 7 abgegebenen Wärme erreicht.

Durch die Ausbildung des Substrathalters 8 als Turbinenlaufrad sind keine das Vakuum in dem Behälter 13 beeinträchtigenden Durchführungen für Wellen, Kabel und dgl. oder ein Motor zum Antrieb des Substrathalters 8 im Behälter 13 mit entsprechendem Partikelabrieb erforderlich.

Auch ist ersichtlich, daß die erfindungsgemäße Vorrichtung aerodynamisch ausgebildet ist, also Gasturbulenzen vermieden werden.

Die Haube 2 und gegebenenfalls der Zylinder 1 der Reaktionskammer sind an ihrer Innenseite mit Siliciumnitrid (Si₃N₄) beschichtet. Auch können der Substrathalter 8 sowie gegebenenfalls das Lager 12 und die Grundplatte 11 aus Si₃N₄-Keramik bestehen oder damit beschichtet sein.

Wie sich gezeigt hat, besitzt nämlich Siliciumnitrid einen sehr geringen Haftkoeffizienten für Arsin, Phosphin und insbesondere DEGaCl, so daß die Gefahr, daß Reste von Arsin, Phosphin bzw. der metallorganischen Galliumverbindung, die auch nach dem Spülzyklus noch an dem Substrathalter 8 haften und bei der anschließenden Zufuhr der metallorganischen Galliumverbindung bzw. von Arsin oder Phosphin zur Bildung von Niederschlägen am Substrathalter 8 oder zu Gasphasenreaktionen führen, weiter beseitigt wird. Aus dem gleichen Grunde ist es vorteilhaft, die Innenwand der Reaktionskammer, also der Haube 2 und des Zylinders 1, sowie die Innenwand der Gasleitungen zur Reaktionskammer mit Siliciumnitrid zu beschichten und die Innenwand der Reaktionskammer sowie die Gasleitungen zur Reaktionskammer durch nicht dargestellte Einrichtungen zu beheizen. Auch ist das Heizelement 14 vorzugsweise als mit Siliciumnitrid beschichteter Graphitwiderstand ausgebildet.

## Patentansprüche

1. Verfahren zum Atomschicht-Epitaxie-Aufwachsen einer Halbleiterdünnschicht auf einer Substratoberfläche, bei dem mit einem Trägergas aus Wasserstoff und einem Edelgas abwechselnd einerseits Arsin oder Phosphin und andererseits eine gasförmige Gallium-, Aluminium- und/oder Indium-Verbindung zugeführt wird, **dadurch gekennzeichnet**, daß als Gallium-, Aluminium- und/oder Indium-Verbindung Gallium-, Aluminium- und/oder Indiumdiethylchlorid eingesetzt wird.

2. Verfahren nach Anspruch 1, **dadurch gekennzeichnet**, daß das Trägergas aus mehr als 50 Vol.-% Edelgas besteht.

3. Verfahren nach einem der vorstehenden Ansprüche, **dadurch gekennzeichnet**, daß die Kammer zwischen der abwechselnden Zuführung der gasförmigen Verbindungen jeweils evakuiert oder mit einem Edelgas gespült wird.

4. Verfahren nach einem der vorstehenden Ansprüche, **dadurch gekennzeichnet**, daß das Edelgas Helium ist.

5. Verfahren nach einem der vorstehenden Ansprüche, **dadurch gekennzeichnet**, daß das Arsin und/oder Phosphin auch bei der Zufuhr des Gallium-, Aluminium- und/oder Indiumdiethylchlorids zugeführt wird, und zwar mit einem Massenfluß, der 1 bis 15 % des maximalen Arsin- und/oder Phosphin-Massenflusses beträgt.

6. Vorrichtung zur Durchführung des Verfahrens nach einem der vorstehenden Ansprüche, mit einer zylindrischen Kammer, in der das Substrat in einer Radialebene auf einer Halterung angeordnet ist, einem Einlaß für die Gase und einer trichterförmigen Haube, welche sich von ihrer Basis an der zylindrischen Kammer zum Gaseinlaß verjüngt, dadurch gekennzeichnet, daß sich die Achse (6) der trichterförmigen Haube (2) von der Zylinderachse (5) der Kammer (1) in einen schrägen Winkel (α) zu dem gegenüber der Zylinderachse (5) der Kammer (1) radial versetzten Gaseinlaß (4) erstreckt und die Radialebene, in der das Substrat (7) angeordnet ist, im Bereich der Basis (3) der Haube (2) angeordnet ist.

7. Vorrichtung nach Anspruch 6, dadurch gekennzeichnet, daß der Winkel (α), den die Trichterachse (6) der Haube (2) gegenüber der Zylinderachse (5) der Kammer (1) einschließt, 20 bis 70° beträgt.

8. Vorrichtung nach Anspruch 6 oder 7, dadurch gekennzeichnet, daß der Substrathalter (8) um die Zylinderachse (5) der Kammer (1) rotierbar ausgebildet ist.

9. Vorrichtung nach Anspruch 8, dadurch gekennzeichnet, daß der Substrathalter (8) als Turbinenlaufrad ausgebildet ist, welches durch das durch den Spalt (18) zwischen dem Substrathalter (8) und der Kammer (1) strömende Gas in Rotation versetzt.

10. Vorrichtung nach einem der Ansprüche 6 bis 9, dadurch gekennzeichnet, daß die Innenwandung der Haube (2), die Innenwandung des Zylinders (1) der Kammer und/oder der Substrathalter (8) mit Siliciumnitrid beschichtet sind.

## Claims

1. A process for atomic layer epitaxial growth of a thin semiconductor layer on a substrate surface, in which arsine or phosphine on one hand alternating with a gaseous gallium, aluminum and/or indium compound on the other hand are supplied with a carrier gas of hydrogen and a noble gas, characterized in that gallium, aluminum and/or indium diethyl chloride are used as gallium, aluminum and/or indium compound.

2. The process as claimed in claim 1, characterized in that the carrier gas is composed of more than 50% by volume of noble gas.

3. The process as claimed in claim 1, characterized in that the chamber is always evacuated or flushed with a noble gas between the alternating supply of the gaseous compounds.

4. The process as claimed in claim 1, characterized in that the noble gas is helium.

5. The process as claimed in anyone of the preceding claims, characterized in that the arsine and/or phosphine is also added while the gallium, aluminum and/or indium diethyl chloride is being supplied, with a mass flow which is 1 to 15% of the maximum arsine and/or phosphine mass flow.

6. An apparatus for carrying out the process according to anyone of the preceding claims, having a cylindrical chamber in which the substrate is disposed in a radial plane on a holder, an inlet for the gases and a funnel-like hood which tapers from its base at the cylindrical chamber to the gas inlet, characterized in that the axis (6) of the funnel-like hood (2) extends at an oblique angle (α) from the cylinder axis (5) of the chamber (1) to the gas inlet (4) which is radially offset with respect to the cylinder axis (5) of the chamber (1) and the radial plane in which the substrate (7) is disposed, is disposed in the region of the base (3) of the hood (2).

7. The apparatus as claimed in claim 6, characterized in that the angle (α), which the funnel axis (6) of the hood (2) includes with respect to the cylinder axis (5) of the chamber (1), is 20 to 70°.

8. The apparatus as claimed in claim 6 or 7, characterized in that the substrate holder (8) is constructed rotatably around the cylinder axis (5) of the chamber (1).

9. The apparatus as claimed in claim 8, characterized in that the substrate holder (8) is constructed as a turbine wheel which is caused to rotate by the gas flowing through the gap (18) between the substrate holder (8) and the chamber (1).

10. The apparatus as claimed in anyone of claims 6 to 9, characterized in that the inside walling of the hood (2), the inside walling of the cylinder (1) of the chamber and/or the substrate holder (8) are coated with silicon nitride.

## Revendications

1. Procédé de croissance épitaxique par couches monoatomiques d'une mince couche de semi-conducteur sur la surface d'un substrat, dans lequel, avec un gaz porteur constitué d'hydrogène et un gaz rare, est alimentée, alternativement, d'une part l'arsine ou la phosphine et, d'autre part, un composé gazeux de gallium, d'aluminium et/ou d'indium, caractérisé en ce que le chlorure de diéthyle de gallium, d'aluminium et/ou d'indium est utilisé comme composé de gallium, d'aluminium et/ou d'indium.

2. Procédé selon la revendication 1, caractérisé en ce que le gaz porteur est composé de plus de 50 % en volume de gaz rare.

3. Procédé selon l'une des revendications précédentes, caractérisé en ce que la chambre, entre la distribution alternative des composés gazeux, est respectivement évacuée ou balayée avec un gaz rare.

4. Procédé selon l'une des revendications précédentes, caractérisé en ce que le gaz rare est de l'hélium.

5. Procédé selon l'une des revendications précédentes, caractérisé en ce que l'arsine et/ou la phosphine est alimentée même en cours de distribution en chlorure de diéthyle de gallium, d'aluminium et/ou d'indium, selon un débit qui représente de 1 à 15 % du débit maximum d'arsine et/ou de phosphine.

6. Dispositif de mise en oeuvre du procédé selon l'une des revendications précédentes, comportant une chambre cylindrique, dans laquelle le substrat est disposé dans un plan radial sur un support, une entrée pour les gaz et une calotte en forme d'entonnoir allant en rétrécissant, de sa base au niveau de la chambre cylindrique, en direction de l'entrée de gaz, caractérisé en ce que l'axe (6) de la calotte (2) en forme d'entonnoir s'étend, à partir de l'axe du cylindre (5) de la chambre (1), selon un angle oblique (α), en direction de l'entrée de gaz (4) décalée radialement par rapport à l'axe du cylindre (5) et en ce que le plan radial, dans lequel le substrat (7) repose, est situé dans la zone de la base (3) de la calotte (2).

7. Dispositif selon la revendication 6, caractérisé en ce que l'angle (α) que forme l'axe de l'entonnoir (6) de la calotte (2) par rapport à l'axe du cylindre (5) de la chambre (1) est de 20 à 70°.

8. Dispositif selon la revendication 6 ou 7, caractérisé en ce que le support (8) de substrat peut tourner autour de l'axe du cylindre (5) de la chambre (1).

9. Dispositif selon la revendication 8, caractérisé en ce que le support (8) de substrat est conformé en roue motrice d'une turbine, qui met en circulation rotationnelle le gaz pénétrant par la fente (18) ménagée entre le support (8) de substrat et la chambre (1).

10. Dispositif selon l'une des revendications 6 à 9, caractérisé en ce que la paroi interne de la calotte (2), la paroi interne du cylindre (1) de la chambre et/ou le support (8) de substrat sont revêtus d'une couche de nitrure de silicium.
